Europäisches Patentamt

European Patent Office

Office européen des brevets

(11) Numéro de publication: **0 229 538 B1**

# FASCICULE DE BREVET EUROPEEN

(45) Date de publication de fascicule du brevet:
**15.05.91**

(51) Int. Cl.⁵: **G06K 19/077**

(21) Numéro de dépôt: **86402465.8**

(22) Date de dépôt: **04.11.86**

(54) **Carte comportant un composant prévue pour être recyclée.**

(30) Priorité: **08.11.85 FR 8516604**

(43) Date de publication de la demande:
**22.07.87 Bulletin  87/30**

(45) Mention de la délivrance du brevet:
**15.05.91 Bulletin  91/20**

(84) Etats contractants désignés:
**CH DE ES FR GB LI NL**

(56) Documents cités:
**GB-A- 2 166 589**

**PATENTS ABSTRACTS OF JAPAN, vol. 9, no. 113 (P-356)[1836], 17 mai 1985; & JP-A-60 589 (KIYOUDOU INSATSU K.K.) 05-01-1985**

(73) Titulaire: **THOMSON COMPOSANTS MILITAI-
RES ET SPATIAUX
173, Bd Haussmann
F-75008 Paris(FR)**

(72) Inventeur: **Gloton, Jean-Pierre
THOMSON-CSF SCPI 19, avenue de Messine
F-75008 Paris(FR)**
Inventeur: **Peres, Philippe
THOMSON-CSF SCPI 19, avenue de Messine
F-75008 Paris(FR)**

(74) Mandataire: **Guérin, Michel et al
THOMSON-CSF SCPI
F-92045 PARIS LA DEFENSE CEDEX 67(FR)**

## Description

La présente invention concerne une carte comportant un composant prévue pour être recyclée. Elle trouve application à la fois dans les domaines de fabrication des cartes à mémoire et dans les utilisations de ces cartes tant en monnetique qu'en sécurité.

Les cartes de type CCC connu de l'art antérieur comportent généralement un semiconducteur sur lequel est implanté un microcalculateur muni d'un moyen de mémoire semiconductrice. Cet organe de mémorisation est permanent et ne permet pas de réutiliser la carte à la fin de son utilisation.

L'invention concerne une carte comportant un composant électronique de type semiconducteur monté dans un micromodule porteur de connexions électriques et protecteur du composant.

Le semiconducteur comporte une zone effaçable par un rayonnement radioélectrique de longueur d'onde déterminée.

Selon l'invention, une carte comportant un composant électronique de type semiconducteur monté dans un micromodule porteur de connexions électriques et protecteur du composant, le semiconducteur comportant une zone effaçable par un rayonnement radioélectrique de longueur d'onde déterminée, caractérisée en ce qu'une lame transparente au rayonnement d'effacement est disposée audessus de la zone à effacer à l'intérieur du micromodule, et en ce que la lame est disposée sur un gel d'espacement, servant à coller la lame sur le semiconducteur.

On va décrire maintenant un moyen effaçable par un rayonnement. D'autres moyens sont possibles qui utilisent un signal d'effacement donné. En particulier, il est possible de dépolariser une certaine partie mémoire par exemple en émettant un signal vers la carte CCC.

L'utilisation d'un rayonnement radio-électrique est soumis aux impératifs de conservation de la carte en usage normal. Autrement dit le rayonnement radioélectrique doit être choisi dans une gamme de longueurs d'onde particulière en dehors des rayonnements parasites habituellement distribués dans l'atmosphère.

D'autres avantages et caractéristiques de la présente invention seront mieux compris à l'aide de la description et des figures annexées qui sont :
- la figure 1, un schéma particulier d'un semiconducteur utilisable dans un carte CCC ;
- la figure 2, un premier mode de réalisation d'un micromodule entrant dans une carte CCC selon l'invention ;
- la figure 3, un second mode de réalisation d'un micromodule rentrant dans une carte CCC selon l'invention ;
- la figure 4, un mode de réalisation d'une carte CCC selon l'invention.

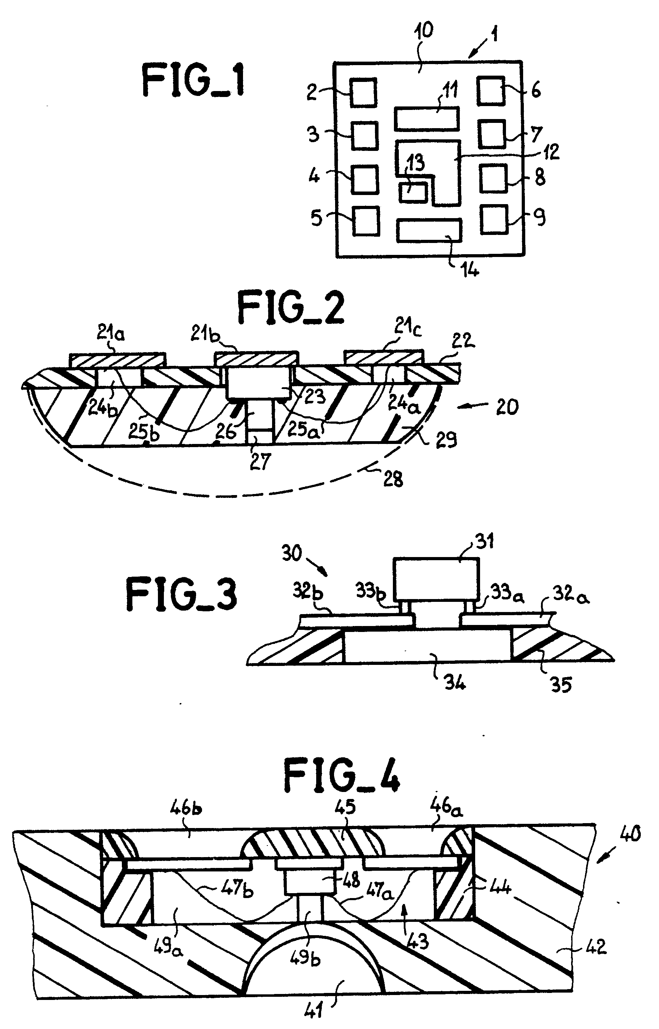

A la figure 1, on a représenté la face supérieure d'un semiconducteur 1 arrangé en microprocesseur. Le microprocesseur comporte des pavés de connexions 2 - 9 sur lequel on disposera des fils de connexions comme il sera vu plus loin. Sur la surface du silicium on dispose par des procédés connus des zones 11 - 14 réalisant différentes fonctions électroniques. En particulier la zone 11 peut consister en un registre de données, la région 12 en une mémoire de données, la région 13 en une unité arithmétique et logique et la région 14 en des moyens d'adressage. Ces différents blocs sont reliés par des avenues de cablage non représentées.

Selon l'invention on utilise une zone 12 mémoire effacable au moyen d'une radiation par exemple dans le domaine des ultra-violets. Ces dispositifs connus sous le nom de EPROM ultra-violet, contiennent des données enregistrées initialement puis effacées au moyen d'une radiation ultra-violette, à volonté.

A la figure 2, on a représenté une partie d'une carte selon l'invention. La carte 29 comporte un micromodule 20 constitué d'un support plastique 22 dont la face externe supérieure au dessin porte des zones métalliques 21 a, b, c de contacts avec un lecteur externe.

La face inférieure du support 22 porte un circuit semiconducteur 23 du genre de la figure 1. Les fils 25 a et b relient les pavés de connexions du genre de la figure 1 aux zones latérales 21 a, c de contacts. Le substrat du semiconducteur 23 est relié sur toute sa surface à la zone de contact centrale 21 b. Sur la face inférieure du support 22 est aussi déposée une goutte 28 de résine protectrice. Cette résine permet d'une part de maintenir l'ensemble des fils du support et du circuit en cohésion mécanique et d'autre part de protéger des agents extérieurs le circuit semiconducteur. Les fils 25 a et 25 b pénètrent jusqu'aux faces inférieures des zones de contact 21 a,c par des trous 24 a, b du support 22. Dans le procédé de fabrication d'un micromodule de ce genre, la partie inférieure de la goutte est meulée de façon à ce que seule la partie 29 en trait plein de la goutte subsiste. Le micromodule 20 est installé ensuite sur une carte CCC. Dans un mode de réalisation selon l'invention on réalise ensuite un perçage de manière à déposer une lame de quartz 27 sur un espaceur 26. La lame de quartz permet de réaliser une interface entre l'extérieure de la carte et l'intérieur du micromodule. Les rayons ultra-violets pénètrent à travers la lame de quartz posée sur l'espaceur 26 et parviennent jusqu'à la zone effacable aux utra-violets.

Dans un autre mode de réalisation non représenté, la lame de quartz est déposée sur une couche de colle directement sur le cristal semiconducteur. L'ensemble est noyé dans la goutte de résine. Celle-ci est ensuite meulie de façon à faire apparaître la fenêtre de quartz.

A la figure 3, on a représenté une variante d'exécution. le circuit semiconducteur 31 est représenté dans la même position que la figure 2. Les pavés de connexion 33a et 33b sont connectés à des poutres 32a, 32b de connexion. Ces poutres sont donc solidaires du circuit semiconducteur. Elles sont aussi solidaires d'un support plastique 35. Ce support est percé d'un alésage au droit du circuit semiconducteur dans lequel on dispose sur les poutrelles 32a et 32b une lame de quartz transparente aux rayons ultra-violets.

A la figure 4, on a représentée une carte CCC réalisée selon l'invention. La carte 40 comporte une partie au format carte de crédit 42 réalisée en matière plastique. Cette carte au format carte de crédit, comporte deux perçages 41 sur la face inférieure et 43 sur la face supérieure. La partie 43 reçoit un micromodule par exemple du genre de la figure 2 ou de la figure 3 ou encore le micromodule dessiné à la figure 4 ainsi qu'il est représenté installé dans l'alésage 43 de la face supérieure de la carte 42.

Un tel micromodule comporte un support plastique 45 sur la face inférieure duquel sont déposées des zones de contacts métalliques analogues aux zones 21 a, b, c de la figure 2, mais sur l'autre face de la figure 2. Les fils 47 a et 47 b relient le circuit semiconducteur 48 directement sans passer par des trous. Un avantage de la présente distribution est de permettre que les zones métalliques de contacts soit largement protégées de l'extérieur. Il faut cependant que le support 45 comporte des perçages 46 a et 46 b au droit des zones de contacts afin que des contacts de l'appareil de lecture puisse accéder aux zones de contact.

Dans l'alésage 43 le micromodule comporte aussi un anneau de garde 44 réalisé en matière plastique qui vient par dessus le reste du micromodule et qui sert d'une part à contenir la résine 49 à araser au cours du procédé de fabrication et d'autre part à ce que le micromodule présente une forme sensiblement cylindrique ou parallélépipédique selon les cas. Une lame de quartz 49 b permet de réaliser l'interface entre la zone effacable aux ultra-violets du circuit 48 avec l'extérieur. L'alésage 41 reçoit des moyens de concentration optique du faisceau ultra-violet. Elle permet de faciliter la transmission de la puissance de la longueur d'ondes fournie pour l'effacement.

Le gel qui sert d'espaceur entre la lame de quartz et la zone à effacer sert aussi de colle de la lame transparente sur le micromodule et la solidarise à celui-ci.

## Revendications

1. Carte comportant un composant électronique de type semiconducteur monté dans un micromodule (20) porteur de connexions électriques (21) et protecteur du composant (23), le semiconducteur (23) comportant une zone effaçable par un rayonnement radioélectrique de longueur d'onde déterminée un élément (27) transparent au rayonnement d'effacement étant disposé au dessus de la zone à effacer à l'intérieur du micromodule caractérisée en ce que cet élément est une lame (27) disposée sur un gel (26) d'espacement transparent au rayonnement d'effacement, servant à coller la lame sur le semiconducteur (23).

2. Carte selon la revendication 1, caractérisée en ce que le micromodule comporte un anneau de garde (44) sur la face libre duquel est disposée la lame transparente.

3. Carte selon l'une des revendications précédentes, caractérisée en ce que le micromodule comporte des connexions en forme de poutres (32) implantées sur la surface du semiconducteur par des plots (33) et sur un support plastique (35) comportant un perçage au droit du semiconducteur (31) dans lequel est déposée la lame transparente (34).

## Claims

1. A board comprising an electronic component of the semiconductor type mounted in a micromodule (20) bearing electrical connections (21) and protecting the component (23), the semiconductor (23) comprising a zone able to be erased by RF radiation with a given wave length, an element (27), which is transparent to such erasing radiation, being positioned on top of the zone to be erased in the interior of the micromodule, characterized in that said element (27) is a sheet positioned (27) on a spacing gel (26) which is transparent to the erasing radiation, serving to bond said sheet on the semiconductor (23).

2. The board as claimed in claim 1, characterized in that the micromodule comprises a guard ring (44) on whose free face the transparent sheet is positioned.

3. The board as claimed in either of the preceding claims, characterized in that the micromodule comprises connections in the form of beams (32) implanted on the surface of the semiconductor by studs (33) and on a synthetic resin support (35) comprising a hole aligned with the semiconductor (31) in which the transparent sheet (34) is located.

## Ansprüche

1. Karte mit einem elektronischen Bauelement, das in einem Mikromodul (20) angebracht ist, der Träger von elektrischen Verbindungen (21) und Schutzvorrichtung des Bauelementes (23) ist, wobei der Halbleiter (23) eine durch radioelektrische Strahlung einer bestimmten Wellenlänge löschbare Zone und ein für die Löschungsstrahlung durchlässiges Element (27), das oberhalb der zu löschenden Zone im Inneren des Mikromoduls angeordnet ist, umfaßt, dadurch gekennzeichnet, daß dieses Element ein Plättchen (27) ist, das auf einem für die Löschungsstrahlung durchlässigen Abstandsgel (26) angeordnet ist, das dem Ankleben des Plättchens am Halbleiter (23) dient.

2. Karte gemäß Anspruch 1, dadurch gekennzeichnet, daß der Mikromodul einen Potentialring (44) enthält, auf dessen freier Seite das durchlässige Plättchen angeordnet ist.

3. Karte gemäß einem der vorangehenden Ansprüche, dadurch gekennzeichnet, daß der Mikromodul Verbindungen in Form von Balken (32) enthält, die auf der Oberfläche des Halbleiters mittels Steckstellen (33) und auf einem Plastikträger (35) implantiert sind, welcher senkrecht unter dem Halbleiter (31) eine Bohrung aufweist, in der das durchlässige Plättchen (34) angeordnet ist.

# FIG_1

# FIG_2

# FIG_3

# FIG_4

5